# FASCICULE DE BREVET EUROPEEN

(11) **EP 3 524 571 B1**
(45) Date de publication et mention de la délivrance du brevet: **16.03.2022**
(21) Numéro de dépôt: 19155441.9
(22) Date de dépôt: 05.02.2019
(51) Int. Cl.: B81C 99/00

(54) **STRUCTURE METALLIQUE ET/OU CERAMIQUE EN MICRO-TREILLIS ET SON PROCEDE DE FABRICATION**
METALLISCHE UND/ODER KERAMISCHE STRUKTUR IN FORM EINES MIKROGEWEBTEN NETZES UND VERFAHREN ZU DESSEN HERSTELLUNG
METAL AND/OR CERAMIC STRUCTURE IN THE SHAPE OF A MICRO-WOVEN MESH METHOD MANUFACTURE THEREOF

(30) Priorité: 09.02.2018 FR 1851123
(43) Date de publication de la demande: 14.08.2019
(73) Titulaire: Commissariat à l'énergie atomique et aux énergies alternatives, 75015 Paris (FR)
(72) Inventeur: DELLEA, Olivier, 38054 GRENOBLE CEDEX 09 (FR); LEBAIGUE, Olivier, 38054 GRENOBLE CEDEX 09 (FR); TARDIF, François, 38054 GRENOBLE CEDEX 09 (FR)
(74) Mandataire: Brevalex

(56) Documents cités:
- WO-A2-2006/130558
- WO-A2-2013/025800
- US-A1- 2015 314 588
- BANAN SADEGHIAN RAMIN ET AL: "Macroporous mesh of nanoporous gold in electrochemical monitoring of superoxide release from skeletal muscle cells", BIOSENSORS AND BIOELECTRONICS, ELSEVIER SCIENCE LTD. UK, AMSTERDAM, NL, vol. 88, 25 juin 2016 (2016-06-25), pages 41-47, XP029804837, ISSN: 0956-5663, DOI: 10.1016/J.BIOS.2016.06.067

## Description

L'invention se rapporte au domaine des structures en micro-treillis, réalisées en matériaux métalliques et/ou céramiques.

L'invention trouve des applications en particulier dans le domaine de l'industrie mécanique, notamment pour ses propriétés d'absorption d'énergie cinétique. Elle trouve également des applications dans les domaines acoustique et thermique.

Les structures en micro-treillis, également connues sous la dénomination anglaise *« micro-lattices »,* ont émergé suite à la recherche de matériaux capables de répondre aux exigences toujours croissantes des cahiers des charges industriels, notamment en matière de légèreté et de résistance mécanique.

De nombreuses techniques ont déjà été proposées pour la réalisation de ces structures, dont les brins convergent vers des nœuds qui sont réputés rigides. Parmi ces techniques, il est noté celle consistant à l'emboutissage, le pliage, puis l'assemblage par brasure des éléments primaires de la structure. D'autres techniques ont également été proposées, comme la méthode des fils assemblés par brasure sur un outillage spécifique, la fabrication additive, ou encore la photolithographie. Le document WO 2013/025800 A2 divulgue une structure en micro treillis formé d'une pluralité de tubes métalliques entrecroisés. Ce document enseigne également un procédé de fabrication d'une structure métallique en micro-treillis, comprenant les étapes qui consistent à former un gabarit de micro-réseau, à revêtir le gabarit de micro-réseau d'un film de matériau métallique et à retirer le gabarit de micro-réseau pour laisser un matériau cellulaire formé d'une pluralité de tubes creux entrecroisés.

Dans tous les cas, la structure en micro-treillis qui est obtenue présente des nœuds rigides, impliquant que les brins situés entre ces nœuds se déforment uniquement en traction ou en compression. Il en résulte un phénomène d'arc-boutement des brins sollicités en compression, qui conduit à un effondrement rapide de la structure sous contrainte.

Ainsi, il subsiste un besoin d'amélioration de la conception de ces structures en micro-treillis, afin qu'elles présentent un comportement mécanique amélioré tout en pouvant être fabriquées en masse, à l'aide de techniques conventionnelles.

Pour répondre à ce besoin, l'invention a pour objet une structure en micro-treillis, comprenant une alternance de premières couches et de secondes couches selon une première direction de la structure ;
chaque première couche comprenant une pluralité de premiers tubes s'étendant chacun dans un plan parallèle à un premier plan de référence défini par ladite première direction de la structure ainsi que par une seconde direction orthogonale à la première ;
chaque seconde couche comprenant une pluralité de seconds tubes s'étendant chacun dans un plan parallèle à un second plan de référence défini par ladite première direction de la structure ainsi que par une troisième direction orthogonale à la première et distincte de la seconde ;
chaque premier tube définissant, selon ladite seconde direction, une alternance de premières et secondes boucles ouvertes respectivement dans un premier sens de la première direction, et dans un second sens de la première direction opposé au premier ;
chaque second tube définissant, selon ladite troisième direction, une alternance de troisièmes et quatrièmes boucles ouvertes respectivement dans le premier sens de la première direction, et dans le second sens de la première direction ;
les premières et secondes couches étant imbriquées les unes dans les autres de telle sorte que chaque première boucle ouverte de chaque premier tube d'une première couche quelconque donnée, est traversée par l'une des quatrièmes boucles ouvertes de l'un des seconds tubes de la seconde couche directement consécutive à ladite première couche donnée selon le second sens de la première direction, les deux boucles concernées étant solidarisées l'une à l'autre au niveau de leurs fonds de boucle respectifs de manière à former un premier nœud de micro-treillis ;
et de telle sorte que chaque seconde boucle ouverte de chaque premier tube de ladite première couche donnée, est traversée par l'une des troisième boucles ouvertes de l'un des seconds tubes de la seconde couche directement consécutive à ladite première couche donnée selon le premier sens de la première direction, les deux boucles concernées étant solidarisées l'une à l'autre au niveau de leurs fonds de boucle respectifs de manière à former un second nœud de micro-treillis.

L'invention se révèle avantageuse tout d'abord en ce qu'elle présente une grande plage de déformation élastique en compression, traction et cisaillement, en raison de la conception particulière qui a été adoptée. En effet, les premiers et seconds nœuds formés aux points de contact entre les fonds de boucles ouvertes peuvent se comporter à la manière de nœuds articulés/rotulés. Les brins convergeant au niveau de ces nœuds ne sont ainsi plus sujets à des risques d'arc-boutement, impliquant que l'effondrement de la structure se révèle bien plus progressif que dans les réalisations de l'art antérieur.

A titre d'exemple indicatif, la structure selon l'invention présente une capacité à se déformer élastiquement qui est de l'ordre de dix fois supérieure à celle rencontrée avec les réalisations de l'art antérieur, avant d'atteindre le seuil de plasticité aux nœuds.

En outre, la structure selon l'invention peut présenter une masse très faible, une haute tenue en température, une grande perméabilité, ainsi qu'une fabrication compatible avec une production de masse de pièces présentant de grands volumes, par exemple supérieurs au décimètre-cube.

Par ailleurs, l'invention prévoit de préférence au moins l'une des caractéristiques optionnelles suivantes, prises isolément ou en combinaison.

De préférence, les premières, secondes, troisièmes et quatrièmes boucles ouvertes sont chacune en forme d'arc de cercle, sur un secteur angulaire compris entre 10 et 180° et plus préférentiellement compris entre 60 et 75°, et selon un rayon de courbure de 0,1 à 10 mm, et plus préférentiellement compris entre 1 et 2 mm.

De préférence, au sein de chaque tube, les boucles ouvertes sont reliées entre elles par des brins de liaison, de préférence droits et de longueur comprise entre 20 et 100 000 µm, et plus préférentiellement entre 6 et 12 mm. Alternativement, ces brins de liaison peuvent être courbes.

De préférence, lesdites seconde et troisième directions sont inclinées l'une par rapport à l'autre selon un angle d'inclinaison allant de 10 à 90°, et préférentiellement de l'ordre de 90°.

De préférence, chaque tube délimite un creux de diamètre compris entre 10 et 1 000 µm.

De préférence, chaque tube présente une épaisseur de paroi comprise entre 0,01 et 300 µm.

De préférence, chaque tube présente une forme périodique dont le motif élémentaire présente une longueur comprise entre 100 et 10 000 µm, et encore plus préférentiellement compris entre 2 et 4 mm.

De préférence, deux premières couches directement consécutives ou deux secondes couches directement consécutives sont espacées l'une de l'autre selon la première direction, d'un pas compris entre 100 et 10 000 µm et encore plus préférentiellement compris entre 3 et 5 mm.

De préférence, la structure présente une densité relative de l'ordre de 0,005 à 0,015, et plus préférentiellement de l'ordre de 0,01.

De préférence, la structure est réalisée en matériau métallique, en matériau céramique, ou selon une combinaison des deux, de préférence à partir d'au moins l'un quelconque des éléments suivants :
- nickel, zinc, chrome, étain, cuivre, or, argent, platine, rhodium, aluminium ;
- diamant, DLC, alumine, zircone, oxyde d'étain, oxyde de zinc, carbure de silicium, nitrure de silicium, nitrure de titane, nitrure de tantale, nitrure de tungstène.

L'invention a également pour objet un procédé de fabrication d'une telle structure métallique et/ou céramique en micro-treillis, comprenant les étapes suivantes :
- réalisation d'un support textile présentant une forme similaire à celle de la structure à réaliser ;
- dépôt du matériau métallique et/ou céramique sur ledit support textile ; et
- de préférence, élimination partielle ou totale dudit support textile.

D'autres avantages et caractéristiques de l'invention apparaîtront dans la description détaillée non limitative ci-dessous.

Cette description sera faite au regard des dessins annexés parmi lesquels ;
- la figure 1 représente une vue en perspective à très grande échelle d'une structure métallique en micro-treillis, selon un mode de réalisation préféré de l'invention ;
- la figure 2 représente une vue de côté de la structure montrée sur la figure 1, selon la troisième direction de la structure ;
- la figure 3 représente une autre vue de côté de la structure montrée sur la figure 1, selon la seconde direction de la structure ; et
- la figure 4 est une vue agrandie en perspective d'une partie de la structure montrée sur la figure 1.

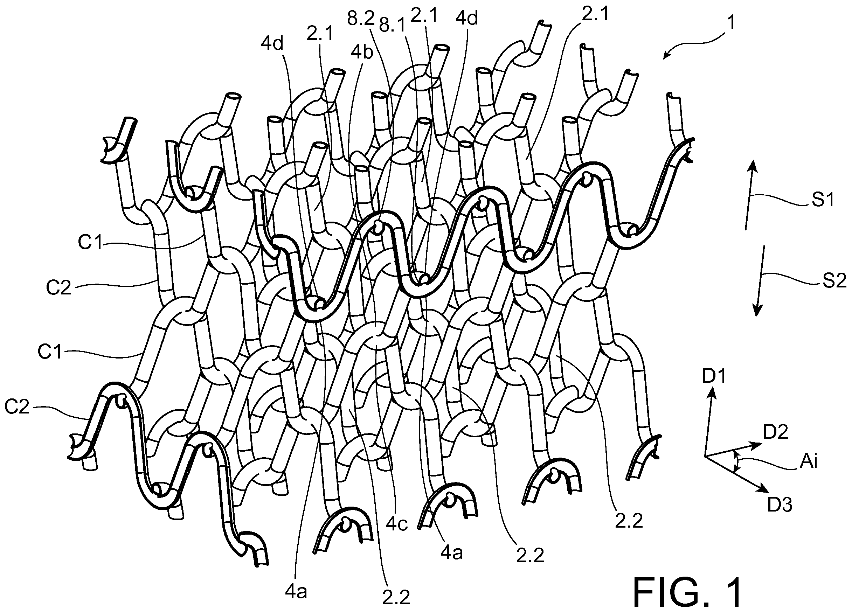

En référence aux figures 1 à 4, il est représenté une structure métallique 1 en micro-treillis, selon un mode de réalisation préféré de l'invention. Cette structure pourrait alternativement être réalisée en céramique, ou bien dans plusieurs matériaux métalliques et céramiques, par exemple sous la forme de revêtements superposés. Un revêtement extérieur en matériau polymère sur les tubes formant la structure est également envisageable, sans sortir du cadre de l'invention.

L'intérêt de cette structure réside essentiellement dans sa grande capacité d'absorption d'énergie mécanique, grâce à l'élasticité procurée par la conception particulière qui va à présent être décrite. Cette conception, dite étagée, est basée sur l'alternance de premières couches C1 et de secondes couches C2, selon une première direction D1 de la structure correspondant à la direction de la hauteur sur les figures.

Chaque première couche C1 comprend une pluralité de premiers tubes 2.1 s'étendant chacun dans un plan parallèle à un premier plan de référence P1, défini par la première direction D1 ainsi que par une seconde direction D2 qui est orthogonale à la direction D1. Les premiers tubes parallèles 2.1 définissent chacun une alternance de premières boucles 4a et de secondes boucles 4b, selon la seconde direction D2. Les premières boucles 4a sont ouvertes dans un premier sens S1 de la première direction D1, tandis que les secondes boucles 4b sont ouvertes dans un second sens S2 de cette première direction, le second sens S2 étant opposé au premier sens S1 et orienté vers le bas sur les figures.

De manière analogue, chaque seconde couche C2 comprend une pluralité de seconds tubes 2.2 s'étendant chacun dans un plan parallèle à un second plan de référence P2, défini par la première direction D1 ainsi que par une troisième direction D3 qui est elle aussi orthogonale à la direction D1, et distincte de la seconde direction D2. Les seconds tubes parallèles 2.2 définissent chacun une alternance de troisièmes boucles 4c et de quatrièmes boucles 4d, selon la troisième direction D3. Les troisièmes boucles 4c sont ouvertes dans le premier sens S1 de la première direction D1, tandis que les quatrièmes boucles 4d sont ouvertes dans le second sens S2 de cette première direction.

Au sein de chaque tube 2.1, 2.2, les boucles successives sont reliées par des brins de liaison 6, qui sont de forme droite ou courbe. Les boucles 4a-4d sont quant à elles préférentiellement en forme d'arc de cercle, ce qui implique que chaque tube adopte préférentiellement une forme proche d'une forme sinusoïdale. A cet égard, il est indiqué que les premiers et seconds tubes 2.1, 2.2 présentent chacun une forme périodique, disposant respectivement des motifs élémentaires Me1 et Me2 qui sont préférentiellement identiques.

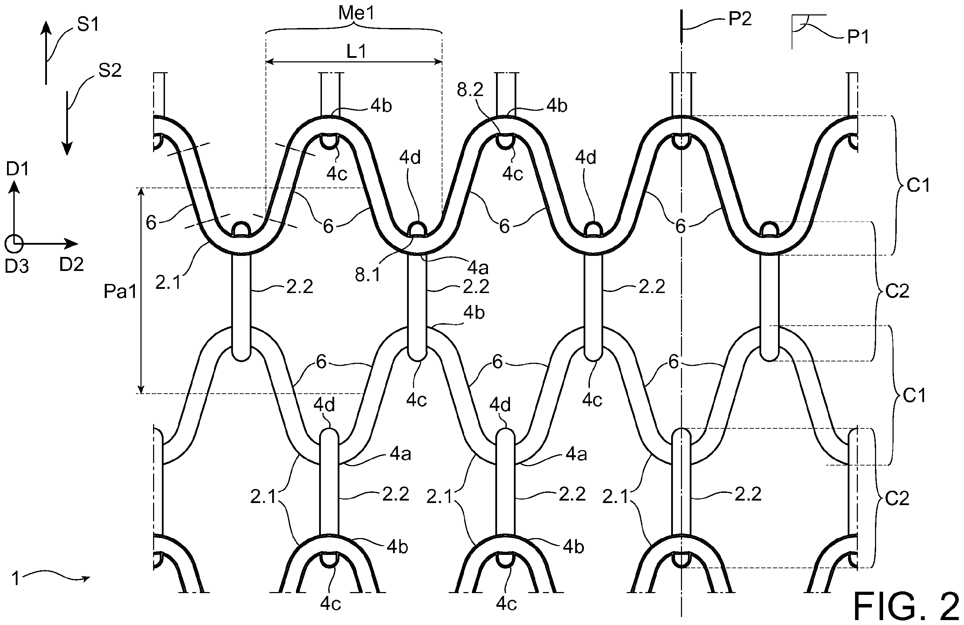

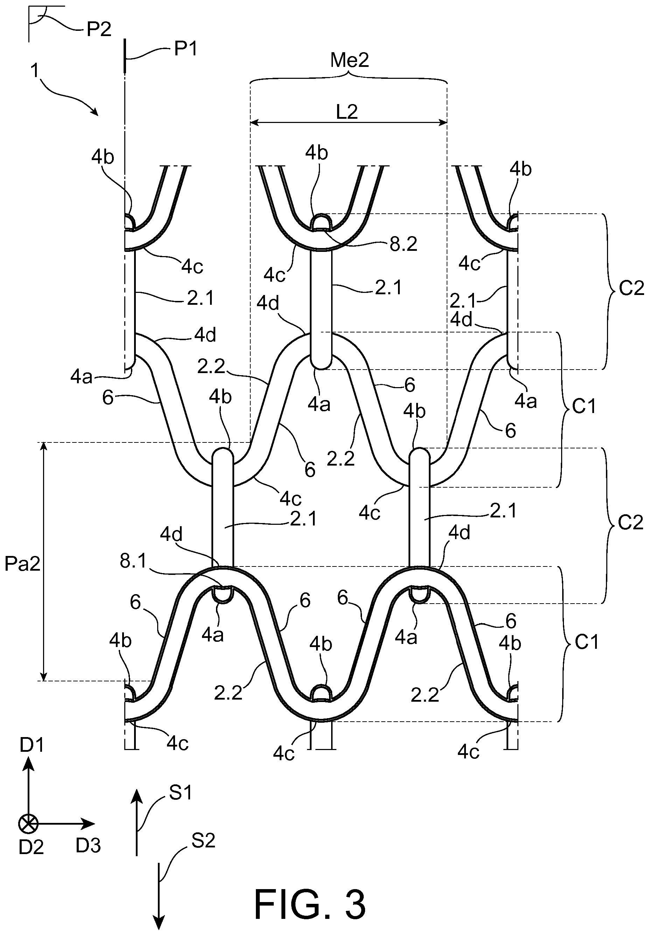

Comme cela est le mieux visible sur les figures 2 et 3, pour deux premières couches C1 directement consécutives dans l'empilement selon la direction D1, les premiers tubes 2.1 de l'une de ces deux couches C1 sont décalés d'une valeur d'une demi-longueur du motif élémentaire Me1 par rapport aux tubes 2.1 de l'autre couche C1. Egalement, pour deux secondes couches C2 directement consécutives dans l'empilement selon la direction D1, les seconds tubes 2.2 de l'une de ces deux couches C2 sont décalés d'une valeur d'une demi-longueur du motif élémentaire Me2 par rapport aux tubes 2.2 de l'autre couche C1. Par conséquent, l'ensemble des premiers tubes 2.1 des premières couches C1 sont agencés en quinconce, de même que l'ensemble formé par les seconds tubes 2.2 des secondes couches C2.

Dans ce mode de réalisation préféré, les seconde et troisième directions D2, D3 sont orthogonales entre-elles, de sorte qu'un angle d'inclinaison Ai d'environ 90° est retenu entre ces deux directions. Néanmoins, l'angle Ai pourrait présenter une valeur différente, par exemple comprise entre 10 et 90°.

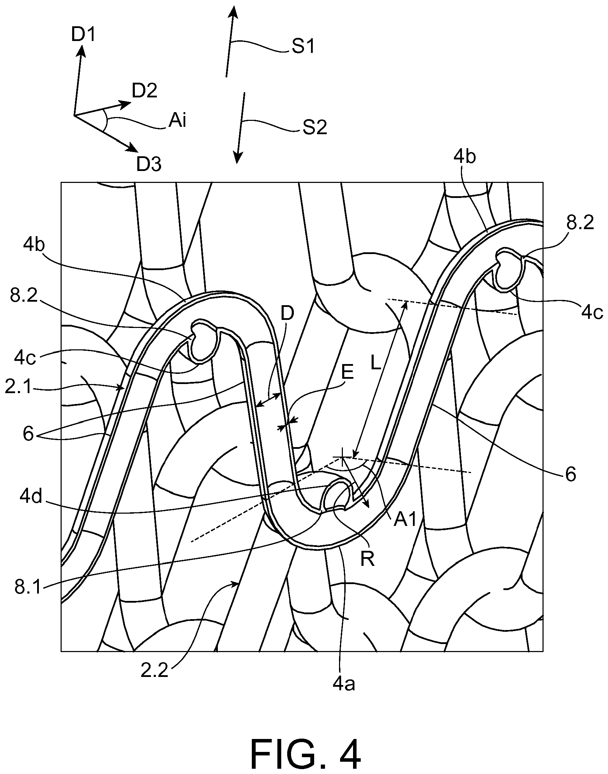

L'une des particularités de l'invention réside dans l'imbrication des couches alternées C1, C2. En effet, chaque première boucle ouverte 4a de chaque premier tube 2.1 d'une première couche quelconque donnée C1, est traversée par l'une des quatrièmes boucles ouvertes 4d de l'un des seconds tubes 2.2 de la seconde couche directement consécutive, selon le second sens S2. Les deux boucles 4a, 4d qui se traversent ici orthogonalement sont solidarisées l'une à l'autre au niveau de leurs fonds de boucle respectifs, de manière à former un premier nœud de micro-treillis, référencé 8.1 sur les figures 1 et 4. Ce premier nœud 8.1, formé par le point de contact à l'intérieur des deux boucles 4a, 4d, présente ainsi une souplesse lui conférant un caractère articulé / rotulé. Chacune de ces boucles 4a, 4d forme deux brins délimités par le nœud 8.1, et ce sont ainsi quatre brins qui s'étendent ici dans deux plans orthogonaux, à partir de ce premier nœud 8.1.

De manière analogue, chaque seconde boucle ouverte 4b de chaque premier tube 2.1 de la première couche quelconque donnée C1, est traversée par l'une des troisièmes boucles ouvertes 4c de l'un des seconds tubes 2.2 de la seconde couche directement consécutive, selon le premier sens S1. Les deux boucles 4b, 4c qui se traversent ici orthogonalement sont solidarisées l'une à l'autre au niveau de leurs fonds de boucle respectifs, de manière à former un second nœud de micro-treillis, référencé 8.2 sur les figures 1 et 4. Ce premier nœud 8.2, formé par le point de contact à l'intérieur des deux boucles 4b, 4c, présente ainsi une souplesse lui conférant un caractère articulé/rotulé. Chacune de ces boucles 4b, 4c forme deux brins délimités par le nœud 8.2, et ce sont ainsi quatre brins qui s'étendent ici dans deux plans orthogonaux, à partir de ce second nœud 8.2.

En référence à présent à la figure 4, il va être décrit le dimensionnement de la structure 1 en micro-treillis, dont le volume peut dépasser le décimètre-cube. Tout d'abord, le secteur angulaire A1 selon lequel s'étend chaque boucle 4a-4d est compris entre 10 et 180°, mais préférentiellement retenu entre 60 et 75°. Le rayon de courbure R de ces arcs de cercle est compris entre 0,1 et 10 mm, et plus préférentiellement entre 1 et 2 mm. La longueur L de chaque brin de liaison 6, reliant deux boucles consécutives de chaque tube, est de l'ordre de 20 et 100 000 µm, et plus préférentiellement comprise entre 6 et 12 mm.

Par ailleurs, chaque tube 2.1, 2.2 délimite un creux de diamètre D compris entre 10 et 1 000 µm, et l'épaisseur de paroi E est comprise entre 0,01 et 300 µm. En outre, deux premières couches C1 directement consécutives sont espacées l'une de l'autre selon la première direction D1, d'un pas Pa1 compris entre 100 et 10 000 µm, et de préférence compris entre 3 et 5 mm. Ce pas Pa1 est référencé sur la figure 2, tandis qu'un pas Pa2 entre deux secondes couches C2 directement consécutives, référencé sur la figure 3, présente une valeur identique au pas Pa1. Enfin, les motifs élémentaires Me1, Me2 présentent respectivement une longueur L1, L2 comprise entre 100 et 10 000 µm, et de préférence comprise entre 2 et 4 mm.

La structure 1 en micro-treillis est réalisée en matériau métallique, de préférence à partir d'au moins l'un quelconque des éléments suivants parmi le nickel, le zinc, le chrome, l'étain, le cuivre, l'or, l'argent, le platine, le rhodium, l'aluminium.

Grâce à la conception particulière à l'invention, il est possible d'obtenir une structure présentant les caractéristiques techniques suivantes :
- masse volumique de 3 à 300 kg.m⁻³;
- densité relative de l'ordre de 0,005 à 0,015, et plus préférentiellement de l'ordre de 0,01 ;
- déformation élastique > 40 % ;
- plage de température d'utilisation de -200 à +400 °C ;
- porosité ouverte > 90 % ;
- conductivité thermique de 0,012 à 1,2 W.m⁻¹.K⁻¹ (dans le vide)

Il va à présent être décrit un procédé préféré de fabrication de la structure 1 en micro-treillis, qui permet une production de masse.

Tout d'abord, il est réalisé un support textile de forme similaire à celle de la structure 1 à fabriquer. Ce support textile peut être du type tricot, et réalisé en matériau polymère.

Ce support textile fait ensuite l'objet d'un dépôt du matériau métallique, par exemple du nickel. Pour effectuer ce dépôt tout autour du support textile, différentes techniques peuvent être employées. Par exemple, le dépôt chimique de nickel sur le textile formant substrat est une possibilité envisageable.

Pour ce faire, il est d'abord procédé à un dégraissage du support textile, par rinçage dans un solvant de type isopropanol (IPA). Ensuite, il est déposé un catalyseur sur le support textile, par immersion dans un bain d'acétate de palladium dilué dans l'isopropanol. Un séchage est ensuite effectué au four à 70°C pendant 1h. Enfin, il est procédé au dépôt de Nickel par immersion dans un bain de NIPOL MPB à 80-86°C pendant plusieurs heures. Le NIPOL MBP est un procédé de nickel chimique moyen phosphore permettant le dépôt d'alliages brillants sur des substrats. Cette technologie est notamment proposée par la société Technic France^{®}.

D'autres techniques de dépôts sont néanmoins possibles, comme le dépôt électrophorétique, ou encore les techniques classiques de CVD et PVD.

Enfin, une dernière étape du procédé de fabrication réside dans l'élimination totale ou partielle du support textile polymère, par des techniques conventionnelles du type hydroxyde de sodium, solvants organiques, plasma, ou pyrolyse.

A titre d'exemple, cette élimination chimique s'effectue par immersion de l'échantillon dans un bain de NaOH à 60°C, pendant 24h.

Cependant, cette étape d'élimination demeure facultative, car le support textile peut être conservé. De ce fait, les tubes de la structure ainsi fabriquée peuvent être creux, entièrement remplis, ou partiellement remplis, de préférence d'une matière polymère ayant servi à la formation des tubes.

Bien entendu, diverses modifications peuvent être apportées par l'homme du métier à l'invention qui vient d'être décrite uniquement à titre d'exemples, et dont la portée est définie par les revendications ci-jointes.

## Revendications

1. Structure métallique et/ou céramique en micro-treillis (1), comprenant une alternance de premières couches (C1) et de secondes couches (C2) selon une première direction (D1) de la structure ;
chaque première couche (C1) comprenant une pluralité de premiers tubes (2.1) s'étendant chacun dans un plan parallèle à un premier plan de référence (P1) défini par ladite première direction (D1) de la structure ainsi que par une seconde direction (D2) orthogonale à la première ;
chaque seconde couche (C2) comprenant une pluralité de seconds tubes (2.2) s'étendant chacun dans un plan parallèle à un second plan de référence (P2) défini par ladite première direction (D1) de la structure ainsi que par une troisième direction (D3) orthogonale à la première et distincte de la seconde ;
chaque premier tube (2.1) définissant, selon ladite seconde direction (D2), une alternance de premières et secondes boucles (4a, 4b) ouvertes respectivement dans un premier sens (S1) de la première direction, et dans un second sens (S2) de la première direction opposé au premier;
chaque second tube (2.2) définissant, selon ladite troisième direction (D3), une alternance de troisièmes et quatrièmes boucles (4c, 4d) ouvertes respectivement dans le premier sens (S1) de la première direction, et dans le second sens (S2) de la première direction ;
les premières et secondes couches étant imbriquées les unes dans les autres de telle sorte que chaque première boucle ouverte (4a) de chaque premier tube (2.1) d'une première couche quelconque donnée (C1), est traversée par l'une des quatrièmes boucles ouvertes (4d) de l'un des seconds tubes (2.2) de la seconde couche (C2) directement consécutive à ladite première couche donnée selon le second sens de (S2) la première direction, les deux boucles concernées (4a, 4d) étant solidarisées l'une à l'autre au niveau de leurs fonds de boucle respectifs de manière à former un premier nœud de micro-treillis (8.1) ;
et de telle sorte que chaque seconde boucle ouverte (4b) de chaque premier tube (2.1) de ladite première couche donnée (C1), est traversée par l'une des troisième boucles ouvertes (4c) de l'un des seconds tubes (2.2) de la seconde couche (C2) directement consécutive à ladite première couche donnée selon le premier sens (S1) de la première direction, les deux boucles concernées (4b, 4c) étant solidarisées l'une à l'autre au niveau de leurs fonds de boucle respectifs de manière à former un second nœud de micro-treillis (8.2).

2. Structure selon la revendication 1, **caractérisée en ce que** les premières, secondes, troisièmes et quatrièmes boucles ouvertes (4a-4d) sont chacune en forme d'arc de cercle, sur un secteur angulaire (A1) compris entre 10 et 180°, et plus préférentiellement compris entre 60 et 75°, et selon un rayon de courbure (R) de 0,1 à 10 mm, et plus préférentiellement compris entre 1 et 2 mm.

3. Structure selon la revendication 1 ou la revendication 2, **caractérisée en ce qu'**au sein de chaque tube (2.1, 2.2), les boucles ouvertes (4a-4d) sont reliées entre elles par des brins de liaison (6), de préférence droits et de longueur (L) comprise entre 20 et 100 000 µm, et plus préférentiellement entre 6 et 12 mm.

4. Structure en micro-treillis selon l'une quelconque des revendications précédentes, **caractérisée en ce que** lesdites seconde et troisième directions (D2, D3) sont inclinées l'une par rapport à l'autre selon un angle d'inclinaison (Ai) allant de 10 à 90°, et préférentiellement de l'ordre de 90°.

5. Structure selon l'une quelconque des revendications précédentes, **caractérisée en ce que** chaque tube (2.1, 2.2) délimite un creux de diamètre (D) compris entre 10 et 1000 µm.

6. Structure selon l'une quelconque des revendications précédentes, **caractérisée en ce que** chaque tube (2.1, 2.2) présente une épaisseur de paroi (E) comprise entre 0,01 et 300 µm.

7. Structure selon l'une quelconque des revendications précédentes, **caractérisée en ce que** chaque tube (2.1, 2.2) présente une forme périodique dont le motif élémentaire (Me1, Me2) présente une longueur (L1, L2) comprise entre 100 et 10 000 µm, et de préférence comprise entre 2 et 4 mm.

8. Structure selon l'une quelconque des revendications précédentes, **caractérisée en ce que** deux premières couches (C1) directement consécutives ou deux secondes couches (C2) directement consécutives sont espacées l'une de l'autre selon la première direction (D1), d'un pas (Pa1, Pa2) compris entre 100 et 10 000 µm, et de préférence compris entre 3 et 5 mm.

9. Structure selon l'une quelconque des revendications précédentes, **caractérisée en ce qu'**elle présente une densité relative de l'ordre de 0,005 à 0,015, et plus préférentiellement de l'ordre de 0,01.

10. Structure selon l'une quelconque des revendications précédentes, **caractérisée en ce qu'**elle est réalisée en matériau métallique, en matériau céramique, ou selon une combinaison des deux, de préférence à partir d'au moins l'un quelconque des éléments suivants :
- nickel, zinc, chrome, étain, cuivre, or, argent, platine, rhodium, aluminium ;
- diamant, DLC, alumine, zircone, oxyde d'étain, oxyde de zinc, carbure de silicium, nitrure de silicium, nitrure de titane, nitrure de tantale, nitrure de tungstène.

11. Procédé de fabrication d'une structure métallique et/ou céramique en micro-treillis (1) selon l'une quelconque des revendications précédentes, **caractérisée en ce qu'**il comprend les étapes suivantes :
- réalisation d'un support textile présentant une forme similaire à celle de la structure à réaliser ;
- dépôt du matériau métallique et/ou céramique sur ledit support textile ; et
- de préférence, élimination partielle ou totale dudit support textile.

## Patentansprüche

1. Metall- und/oder Keramikstruktur aus Mikrogittem (1), eine Abwechslung von ersten Schichten (C1) und von zweiten Schichten (C2) in einer ersten Richtung (D1) der Struktur umfassend;
wobei jede erste Schicht (C1) eine Vielzahl von ersten Röhren (2.1) umfasst, die sich jeweils in einer Ebene parallel zu einer ersten Referenzebene (P1) erstrecken, die durch die erste Richtung (D1) der Struktur, sowie durch eine zweite Richtung (D2) senkrecht zur ersten definiert wird;
wobei jede zweite Schicht (C2) eine Vielzahl von zweiten Röhren (2.2) umfasst, die sich jeweils in einer Ebene parallel zu einer zweiten Referenzebene (P2) erstrecken, die durch die erste Richtung (D1) der Struktur, sowie durch eine dritte Richtung (D3) senkrecht zur ersten und unterschiedlich zur zweiten definiert wird;
wobei jede erste Röhre (2.1) in der zweiten Richtung (D2) eine Abwechslung von ersten und zweiten, jeweils in einer ersten Laufrichtung (S1) der ersten Richtung und in einer zweiten Laufrichtung (S2) der ersten Richtung entgegengesetzt zur ersten, offenen Schleifen (4a, 4b) definiert;
wobei jede zweite Röhre (2.2) in der dritten Richtung (D3) eine Abwechslung von dritten und vierten, jeweils in einer ersten Laufrichtung (S1) der ersten Richtung und in einer zweiten Laufrichtung (S2) der ersten Richtung, offenen Schleifen (4c, 4d) definiert;
wobei die ersten und zweiten Schichten derart ineinander verschachtelt sind, dass jede erste offene Schleife (4a) einer jeden ersten Röhre (2.1) einer beliebigen gegebenen ersten Schicht (C1) von einer der offenen vierten Schleifen (4d) der einen der zweiten Röhren (2.2) der zweiten Schicht (C2) direkt auf die erste gegebene Schicht gemäß der zweiten Laufrichtung (S2) der ersten Richtung folgend durchquert wird, wobei die beiden betroffenen Schleifen (4a, 4d) im Bereich ihrer jeweiligen Schleifengründe derart fest miteinander verbunden sind, um einen ersten Mikrogitterknoten (8.1) zu bilden;
und derart, dass jede zweite offene Schleife (4b) einer jeden ersten Röhre (2.1) der ersten gegebenen Schicht (C1) von einer der dritten offenen Schleifen (4c) von einer der zweiten Röhren (2.2) der zweiten Schicht (C2) direkt auf die erste gegebenen Schicht gemäß der ersten Laufrichtung (S1) der ersten Richtung folgenden durchquert wird, wobei die beiden betroffenen Schleifen (4b, 4c) im Bereich ihrer jeweiligen Schleifengründe derart fest miteinander verbunden sind, um einen zweiten Mikrogitterknoten (8.2) zu bilden.

2. Struktur nach Anspruch 1, **dadurch gekennzeichnet, dass** die ersten, zweiten, dritten, und vierten offenen Schleifen (4a-4d) in einem Winkelsektor (A1), der zwischen 10 und 180° liegt, und vorzugsweise zwischen 60 und 75° liegt, und entsprechend einem Biegeradius (R), der zwischen 0,1 bis 10 mm, und bevorzugter zwischen 1 und 2 mm liegt, jeweils in Kreisbogenform sind.

3. Struktur nach Anspruch 1 oder Anspruch 2, **dadurch gekennzeichnet, dass** die offenen Schleifen (4a-4d) innerhalb jeder Röhre (2.1, 2.2) durch Verbindungsstränge (6), vorzugsweise gerade und in einer Länge (L), die zwischen 20 und 100.000 µm, und bevorzugter zwischen 6 und 12 mm liegt, miteinander verbunden sind.

4. Struktur aus Mikrogittem nach einem der vorstehenden Ansprüche, **dadurch gekennzeichnet, dass** die zweite und dritte Richtung (D2, D3) in Bezug zueinander um einen Neigungswinkel (Ai), der von 10 bis 90° reicht, und vorzugsweise in der Größenordnung von 90° ist, zueinander geneigt sind.

5. Struktur nach einem der vorstehenden Ansprüche, **dadurch gekennzeichnet, dass** jede Röhre (2.1, 2.2) einen Hohlraum im Durchmesser (D), der zwischen 10 und 1.000 µm liegt, begrenzt wird.

6. Struktur nach einem der vorstehenden Ansprüche, **dadurch gekennzeichnet, dass** jede Röhre (2.1, 2.2) eine Wanddicke (E) aufweist, die zwischen 0,01 und 300 µm liegt.

7. Struktur nach einem der vorstehenden Ansprüche, **dadurch gekennzeichnet, dass** jede Röhre (2.1, 2.2) eine periodische Form aufweist, deren elementares Motiv (Me1, Me2) eine Länge (L1, L2) aufweist, die zwischen 100 und 10.000 µm liegt, und vorzugsweise zwischen 2 und 4 mm liegt.

8. Struktur nach einem der vorstehenden Ansprüche, **dadurch gekennzeichnet, dass** zwei direkt aufeinanderfolgende erste Schichten (C1) oder zwei direkt aufeinanderfolgende zweite Schichten (C2) in der ersten Richtung (D1) um eine Teilung (Pa1, Pa2) voneinander beabstandet sind, der zwischen 100 und 10.000 µm liegt, und vorzugsweise zwischen 3 und 5 mm liegt.

9. Struktur nach einem der vorstehenden Ansprüche, **dadurch gekennzeichnet, dass** sie eine relative Dichte in der Größenordnung von 0,005 bis 0,015, und bevorzugter in der Größenordnung von 0,01 aufweist.

10. Struktur nach einem der vorstehenden Ansprüche, **dadurch gekennzeichnet, dass** sie aus einem metallischen Material, aus einem keramischen Material, oder entsprechend einer Kombination der beiden, vorzugsweise aus mindestens einem beliebigen der folgenden Elemente gefertigt ist:
- Nickel, Zink, Chrom, Zinn, Kupfer, Gold, Silber, Platin, Rhodium, Aluminium;
- Diamant, DLC, Aluminiumoxid, Zikronoxid, Zinnoxid, Zinkoxid, Siliziumkarbid, Siliziumnitrid, Titannitrid, Tantalnitrid, Wolframnitrid.

11. Verfahren zur Herstellung einer Metall- und/oder Keramikstruktur aus Mikrogittern (1) nach einem der vorstehenden Ansprüche, **dadurch gekennzeichnet, dass** es die folgenden Schritte umfasst:
- Fertigen eines textilen Trägers, der eine ähnliche Form zu jener der zu fertigenden Struktur aufweist;
- Abscheiden des Metall- und/oder Keramikmaterials auf dem textilen Träger; und
- vorzugsweise teilweise oder vollständige Entfernung des textilen Trägers.

## Claims

1. Metal and/or ceramic microlattice structure (1), comprising an alternation of first layers (C1) and of second layers (C2) in a first direction (D1) of the structure;
each first layer (C1) comprising a plurality of first tubes (2.1) each extending in a plane parallel to a first reference plane (P1) defined by said first direction (D1) of the structure as well as by a second direction (D2) orthogonal to the first;
each second layer (C2) comprising a plurality of second tubes (2.2) each extending in a plane parallel to a second reference plane (P2) defined by said first direction (D1) of the structure as well as by a third direction (D3) orthogonal to the first and distinct from the second;
each first tube (2.1) defining, in said second direction (D2), an alternation of first and second loops (4a, 4b) open, respectively, in a first heading (S1) of the first direction, and in a second heading (S2) of the first direction opposite to the first;
each second tube (2.2) defining, in said third direction (D3), an alternation of third and fourth loops (4c, 4d) open, respectively, in the first heading (S1) of the first direction, and in the second heading (S2) of the first direction;
the first and second layers being interlocking with each other in such a way that through each first open loop (4a) of each first tube (2.1) of any given first layer (C1), one of the fourth open loops (4d) of one of the second tubes (2.2) of the second layer (C2) directly consecutive to said first given layer in the second heading (S2) of the first direction passes, the two loops in question (4a, 4d) being rigidly connected to each other at their respective loop bottoms in such a way as to form a first microlattice node (8.1);
and in such a way that through each second open loop (4b) of each first tube (2.1) of said first given layer (C1), one of the third open loops (4c) of one of the second tubes (2.2) of the second layer (C2) directly consecutive to said first given layer in the first heading (S1) of the first direction passes, the two loops in question (4b, 4c) being rigidly connected to each other at their respective loop bottoms in such a way as to form a second microlattice node (8.2).

2. Structure according to claim 1, **characterised in that** the first, second, third and fourth open loops (4a-4d) are each in the shape of an arc of a circle, over an angular sector (A1) of between 10 and 180°, and more preferably between 60 and 75°, and according to a radius of curvature (R) of 0.1 to 10mm, and more preferably between 1 and 2mm.

3. Structure according to claim 1 or claim 2, **characterised in that** in each tube (2.1, 2.2), the open loops (4a-4d) are connected to each other by linking struts (6), preferably straight and having a length (L) between 20 and 100,000µm, and more preferably between 6 and 12mm.

4. Microlattice structure according to any of the preceding claims, **characterised in that** said second and third directions (D2, D3) are inclined with respect to one another according to an angle of inclination (Ai) ranging from 10 to 90°, and preferably of approximately 90°.

5. Structure according to any of the preceding claims, **characterised in that** each tube (2.1, 2.2) defines a hollow having a diameter (D) between 10 and 1000µm .

6. Structure according to any of the preceding claims, **characterised in that** each tube (2.1, 2.2) has a wall thickness (E) between 0.01 and 300µm.

7. Structure according to any of the preceding claims, **characterised in that** each tube (2.1, 2.2) has a periodic shape, the elementary pattern (Me1, Me2) of which has a length (L1, L2) between 100 and 10,000µm, and preferably between 2 and 4mm.

8. Structure according to any of the preceding claims, **characterised in that** two directly consecutive first layers (C1) or two directly consecutive second layers (C2) are spaced apart from each other in the first direction (D1), by a space (Pa1, Pa2) of between 100 and 10,000µm, and preferably between 3 and 5mm.

9. Structure according to any of the preceding claims, **characterised in that** it has a relative density of approximately 0.005 to 0.015, and more preferably of approximately 0.01.

10. Structure according to any of the preceding claims, **characterised in that** it is made from a metal material, from a ceramic material, or according to a combination of the two, preferably from at least any one of the following elements:
- nickel, zinc, chromium, tin, copper, gold, silver, platinum, rhodium, aluminium;
- diamond, DLC, alumina, zirconia, tin oxide, zinc oxide, silicon carbide, silicon nitride, titanium nitride, tantalum nitride, tungsten nitride.

11. Method for manufacturing a metal and/or ceramic microlattice structure (1) according to any of the preceding claims, **characterised in that** it comprises the following steps:
- creation of a textile support having a shape similar to that of the structure to be made;
- deposition of the metal and/or ceramic material onto said textile support; and
- preferably, partial or total elimination of said textile support.
